# EUROPEAN PATENT SPECIFICATION

(11) **EP 1 559 743 B1**
(45) Date of publication and mention of the grant of the patent: **18.02.2009**
(21) Application number: 04257697.5
(22) Date of filing: 10.12.2004
(51) Int. Cl.: C08K 3/38, C08K 3/22, C08K 5/00, C08G 63/16, C08G 63/189, C08G 63/181, C08G 63/183

(54) **Infra-red radiation absorption articles and method of manufacturing thereof**
Infrarot-Strahlung absorbierende Artikel und Methode zu deren Herstellung
Articles ayant une absorption dans le domaine Infrarouge et procédé de fabrication de ces articles

(30) Priority: 28.01.2004 US 539828 P; 30.09.2004 US 955038
(43) Date of publication of application: 03.08.2005
(73) Proprietor: Sabic Innovative Plastics IP B.V., 4612 PX Bergen op Zoom (NL)
(72) Inventor: Van den Bogerd, Jos, 4597 GV Sint Annaland (NL); Faber, Rein Mollerus, 4617 JS Bergen op Zoom (NL); Maas, Christianus J. J., 4411 DM Rilland (NL)
(74) Representative: Modiano, Micaela Nadia

(56) References cited:
- WO-A-95/02504
- US-A- 4 031 063
- US-A- 4 250 078
- US-A- 4 895 904
- US-A- 6 022 920

## Description

### REFERENCE TO RELATED APPLICATIONS

This application claims priority to U.S. Provisional Application Serial No. 60/539,828, filed January 28, 2004.

### BACKGROUND

This disclosure relates to infra-red radiation absorption articles and methods of manufacture thereof.

Absorption of excessive amounts of solar radiation by the interior surfaces of a vehicle, residential home or office building can result in elevated interior temperatures, reduced comfort for the occupants, accelerated degradation of interior materials, and an increase in the requirement for larger air conditioning units. In vehicles especially, under high static-soak conditions, which can occur in vehicles parked in the hot summer sun, especially in a desert climate, surface temperature within a closed car can reach over 100°C, and the entire thermal mass of the car can be raised to high temperatures.

Increasing the cooling load of the air conditioning unit in a vehicle to ameliorate heat discomfort would go against the trend currently prevailing in the automobile industry. Automobile engines are being downsized to reduce weight and improve fuel efficiency and are less able to handle the power drain of the larger air conditioners. A recent concern to industry and Government is the role played by automotive air conditioners as a source of chlorofluorocarbons (CFC) released into the atmosphere, increased cooling load will lead to even larger air conditioning units, which will exacerbate this problem.

In an attempt to reduce the heat build-up and the consequent increase in temperatures in automobiles, buildings, and the like, there have been attempts to include inorganic infra-red absorbers into transparent materials that are used as windows. These infrared absorbers are typically metal salts of borides. This solution however is not successful, in that, the inorganic IR absorbers suffer from a lack of hydrolytic stability and degrade over time. Thus, there is a need for new technologies and passive design solutions, which would lead to long term reduced solar heat loads in automobiles, residential and office buildings, and the like.

### SUMMARY

Disclosed herein is a composition as defined in appended claims 1-16 comprising an organic polymer; an inorganic infrared absorbing additive; and an ultraviolet absorbing additive.

Disclosed herein too is a method of manufacturing a composition as defined in appended claims 17-21 comprising melt
blending a composition comprising an organic polymer; an inorganic infrared absorbing additive; and an ultraviolet absorbing additive.

Disclosed herein too are articles comprising the composition detailed above as well as articles manufactured by the method detailed above.

### DESCRIPTION OF THE FIGURE

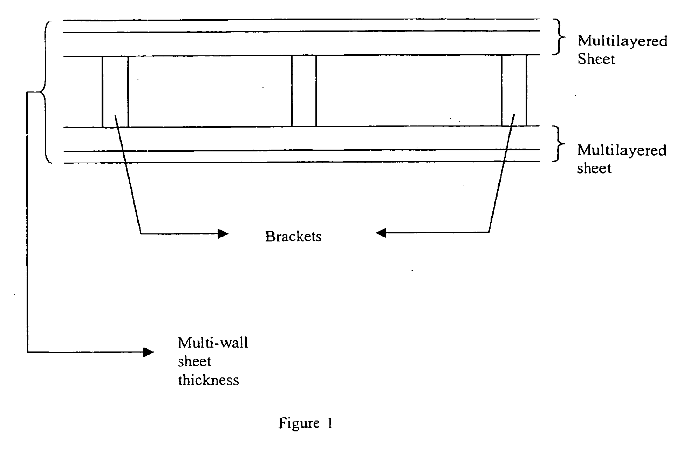

Figure 1 depicts a multiwall sheet wherein the respective sheets are separated by brackets and having air pockets in between the brackets.

### DETAILED DESCRIPTION OF PREFERRED EMBODIMENTS

Disclosed herein are articles such as films, sheets, plaques, and the like, that display long term high absorption and high reflectance of light in the near infrared (IR) region, while providing high transmittance and low reflectance for light in the visible region of the electromagnetic spectrum. All references to IR and UV in this disclosure are in relationship to the electromagnetic spectrum. The article may comprise a single layer or may be multilayered. Without being limited by theory, it is believed that a synergistic interaction between the UV absorbing additive and the inorganic IR absorbing additive increases the hydrolytic stability of the inorganic IR absorbing additive. This synergistic interaction permits the inorganic IR absorbing additive and hence the article to absorb IR radiation for an extended period of time without any loss in the absorption capabilities. It is to be noted that all ranges disclosed herein are inclusive and combinable.

As stated above, the article comprises a composition comprising an organic polymer, an inorganic IR absorbing additive and a UV absorbing additive. The organic polymer may be a thermoplastic polymer or a thermosetting polymer. Preferred organic polymers are aromatic thermoplastic polymers, aromatic thermosetting polymers, or mixtures of aromatic thermosetting polymers with aromatic thermoplastic polymers. Thermoplastic polymers that may be used are oligomers, homopolymers, ionomers, dendrimers, copolymers such as block copolymers, graft copolymers, star block copolymers, random copolymers, and the like, as well as combinations comprising at least one of the foregoing polymers. Suitable examples of thermoplastic polymers that can be used are polyacetals, polyacrylics, polyalkyds, polycarbonates polystyrenes, polyesters, polyamides, polyamideimides, polyarylates, polyarylsulfones, polyethersulfones, polyphenylene sulfides, polyvinyl chlorides, polysulfones, polyimides, polyetherimides, polytetrafluoroethylenes, polyetherketones, polyether etherketones, polyether ketone ketones, polybenzoxazoles, polyoxadiazoles, polybenzothiazinophenothiazines, polybenzothiazoles, polypyrazinoquinoxalines, polypyromellitimides, polyquinoxalines, polybenzimidazoles, polyoxindoles, polyoxoisoindolines, polydioxoisoindolines, polytriazines, polypyridazines, polypiperazines, polypyridines, polypiperidines, polytriazoles, polypyrazoles, polypyrrolidines, polycarboranes, polyoxabicyclononanes, polydibenzofurans, polyphthalides, polyacetals, polyanhydrides, polyvinyl ethers, polyvinyl thioethers, polyvinyl alcohols, polyvinyl ketones, polyvinyl halides, polyvinyl nitriles, polyvinyl esters, polysulfonates, polysulfides, polythioesters, polysulfones, polysulfonamides, polyureas, polyphosphazenes, polysilazanes, or the like, or combinations comprising at least one of the foregoing thermoplastic polymers. The preferred thermoplastic polymers for use in the composition are thermoplastic polymers such as polycarbonates, copolymers of polycarbonate and polysiloxane, copolyestercarbonates, or blends of polyesters with polycarbonates. As stated above, aromatic thermoplastic polymers are generally preferred.

Blends of thermoplastic polymers may also be used. Suitable examples of blends of thermoplastic polymers include acrylonitrile-butadiene-styrene/nylon, polycarbonate/acrylonitrile-butadiene-styrene, acrylonitrile butadiene styrene/polyvinyl chloride, polyphenylene ether/polystyrene, polyphenylene ether/nylon, polysulfone/acrylonitrile-butadiene-styrene, polycarbonate/thermoplastic urethane, polycarbonate/polyethylene terephthalate, polycarbonate/polybutylene terephthalate, thermoplastic elastomer alloys, nylon/elastomers, polyester/elastomers, polyethylene terephthalate/polybutylene terephthalate, styrene-maleicanhydride/acrylonitrile-butadiene-styrene, polyether etherketone/polyethersulfone, polyether etherketone/polyetherimide polyethylene/nylon, polyethylene/polyacetal, or the like.

Suitable examples of thermosetting polymers include polyurethanes, natural rubber, epoxies, phenolics, polyesters, polyamides, polysiloxanes, or the like, or mixtures comprising at least one of the foregoing thermosetting resins. Aromatic thermosetting polymers are generally preferred. Blends of thermosetting polymers as well as blends of thermoplastic polymers with thermosetting polymers can be utilized.

It is preferred for the thermoplastic polymer to be transparent to light in the optical wavelength region of the electromagnetic spectrum. As noted above, polycarbonate may be one of the thermoplastic polymers used in the composition. As used herein, the terms "polycarbonate", "polycarbonate composition", and "composition comprising aromatic carbonate chain units" includes compositions having structural units of the formula (I): 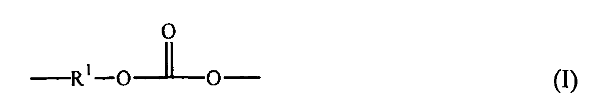 in which greater than or equal to about 60 percent of the total number of R¹ groups are aromatic organic radicals and the balance thereof are aliphatic, alicyclic, or aromatic radicals. Preferably, R¹ is an aromatic organic radical and, more preferably, a radical of the formula (II):

-A¹-Y¹-A²- (II)

wherein each of A¹ and A² is a monocyclic divalent aryl radical and Y¹ is a bridging radical having zero, one, or two atoms which separate A¹ from A². In an exemplary embodiment, one atom separates A¹ from A². Illustrative examples of the Y¹ radicals are -O-, -S-, -S(O)-, -S(O)₂-, -C(O)-, methylene, cyclohexyl-methylene, 2-[2,2,1]-bicycloheptylidene, ethylidene, isopropylidene, neopentylidene, cyclohexylidene, cyclopentadecylidene, cyclododecylidene, adamantylidene, or the like. In another embodiment, zero atoms separate A¹ from A², with an illustrative example being biphenyl. The bridging radical Y¹ can be a saturated hydrocarbon group such as methylene, cyclohexylidene or isopropylidene.

Polycarbonates may be produced by the Schotten-Bauman interfacial reaction of a carbonate precursor with dihydroxy compounds. Typically, an aqueous base such as sodium hydroxide, potassium hydroxide, calcium hydroxide, or the like, is mixed with an organic, water immiscible solvent such as benzene, toluene, carbon disulfide, chloro-benzene, chloroform or dichloromethane, which contains the dihydroxy compound. A phase transfer agent is generally used to facilitate the reaction. As carbonate precursor carbonyl halides are employed. The preferred carbonyl halide is carbonyl chloride (phosgene). Molecular weight regulators may be added either singly or in admixture to the reactant mixture. Branching agents, described forthwith may also be added singly or in admixture.

Polycarbonates can be produced by the interfacial reaction of dihydroxy compounds in which only one atom separates A¹ and A². As used herein, the term "dihydroxy compound" includes, for example, bisphenol compounds having general formula (III) as follows: 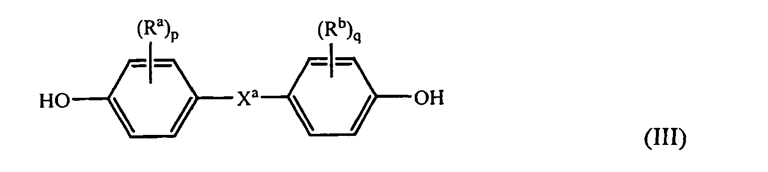 wherein R^{a} and R^{b} each independently represent hydrogen, a halogen atom, preferably bromine, or a monovalent hydrocarbon group, p and q are each independently integers from 0 to 4, and X^{a} represents one of the groups of formula (IV): 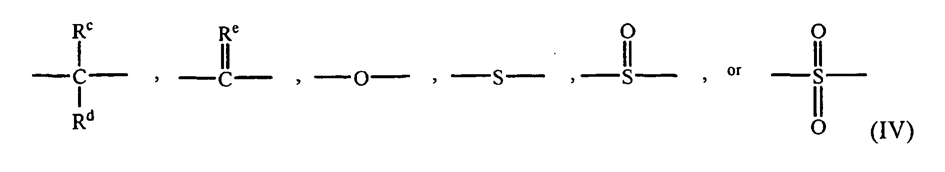 wherein R^{c} and R^{d} each independently represent a hydrogen atom or a monovalent linear or cyclic hydrocarbon group, and R^{e} is a divalent hydrocarbon group, oxygen, or sulfur.

Examples of the types of bisphenol compounds that may be represented by formula (III) include the bis(hydroxyaryl)alkane series such as, 1,1-bis(4-hydroxyphenyl)methane, 1,1-bis(4-hydroxyphenyl)ethane, 2,2-bis(4-hydroxyphenyl)propane (or bisphenol-A), 2,2-bis(4-hydroxyphenyl)butane, 2,2-bis(4-hydroxyphenyl)octane, 1,1-bis(4-hydroxyphenyl)propane, 1,1-bis(4-hydroxyphenyl)n-butane, bis(4-hydroxyphenyl)phenylmethane, 2,2-bis(4-hydroxy-1-methylphenyl)propane, 1,1-bis(4-hydroxy-t-butylphenyl)propane, 2,2-bis(4-hydroxy-3-bromophenyl)propane, or the like; bis(hydroxyaryl)cycloalkane series such as, 1,1-bis(4-hydroxyphenyl)cyclopentane, 1,1-bis(4-hydroxyphenyl)cyclohexane, or the like, or combinations comprising at least one of the foregoing bisphenol compounds.

Other bisphenol compounds that may be represented by formula (III) include those where X is -O-, -S-, -SO- or -S(O)₂-. Some examples of such bisphenol compounds are bis(hydroxyaryl)ethers such as 4,4'-dihydroxy diphenylether, 4,4'-dihydroxy-3,3'-dimethylphenyl ether, or the like; bis(hydroxy diaryl)sulfides, such as 4,4'-dihydroxy diphenyl sulfide, 4,4'-dihydroxy-3,3'-dimethyl diphenyl sulfide, or the like; bis(hydroxy diaryl) sulfoxides, such as, 4,4'-dihydroxy diphenyl sulfoxides, 4,4'-dihydroxy-3,3'-dimethyl diphenyl sulfoxides, or the like; bis(hydroxy diaryl)sulfones, such as 4,4'-dihydroxy diphenyl sulfone, 4,4'-dihydroxy-3,3'-dimethyl diphenyl sulfone, or the like; or combinations comprising at least one of the foregoing bisphenol compounds.

Other bisphenol compounds that may be utilized in the polycondensation of polycarbonate are represented by the formula (V) 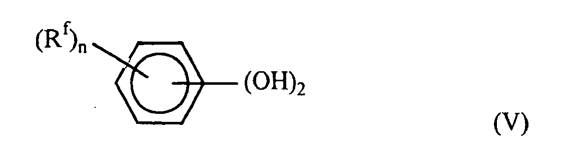 wherein, R^{f}, is a halogen atom or a hydrocarbon group having 1 to 10 carbon atoms or a halogen substituted hydrocarbon group; n is a value from 0 to 4. When n is at least 2, R^{f} may be the same or different. Examples of bisphenol compounds that may be represented by the formula (V), are resorcinol, substituted resorcinol compounds such as 5-methyl resorcin, 5-ethyl resorcin, 5-propyl resorcin, 5-butyl resorcin, 5-t-butyl resorcin, 5-phenyl resorcin, 5-cumyl resorcin, or the like; catechol, hydroquinone, substituted hydroquinones, such as 3-methyl hydroquinone, 3-ethyl hydroquinone, 3-propyl hydroquinone, 3-butyl hydroquinone, 3-t-butyl hydroquinone, 3-phenyl hydroquinone, 3-cumyl hydroquinone, or the like; or combinations comprising at least one of the foregoing bisphenol compounds.

Bisphenol compounds such as 2,2, 2', 2'- tetrahydro-3, 3, 3', 3'- tetramethyl-1, 1'-spirobi-[IH-indene]-6, 6'- diol represented by the following formula (VI) may also be used.

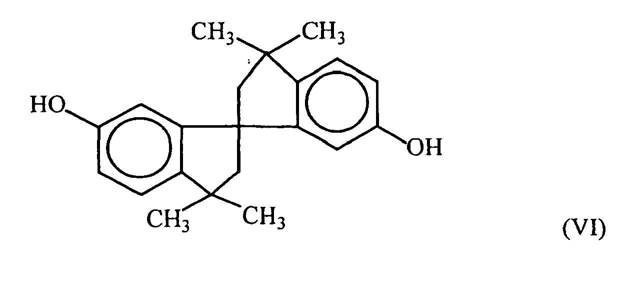

Suitable polycarbonates further include those derived from bisphenols containing alkyl cyclohexane units. Such polycarbonates have structural units corresponding to the formula (VII) 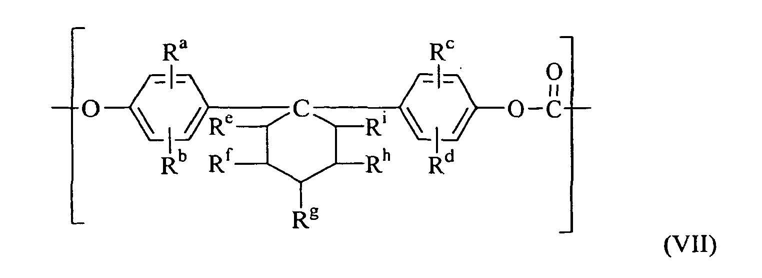 wherein R^{a}-R^{d} are each independently hydrogen, C₁-C₁₂ hydrocarbyl, or halogen; and R^{e}-Rⁱ are each independently hydrogen, C₁-C₁₂ hydrocarbyl. As used herein, "hydrocarbyl" refers to a residue that contains only carbon and hydrogen. The residue may be aliphatic or aromatic, straight-chain, cyclic, bicyclic, branched, saturated, or unsaturated. The hydrocarbyl residue may contain heteroatoms over and above the carbon and hydrogen members of the substituent residue. Thus, when specifically noted as containing such heteroatoms, the hydrocarbyl residue may also contain carbonyl groups, amino groups, hydroxyl groups, or the like, or it may contain heteroatoms within the backbone of the hydrocarbyl residue. Alkyl cyclohexane containing bisphenols, for example the reaction product of two moles of a phenol with one mole of a hydrogenated isophorone, are useful for making polycarbonate polymers with high glass transition temperatures and high heat distortion temperatures. Such isophorone bisphenol-containing polycarbonates have structural units corresponding to the formula (VIII) 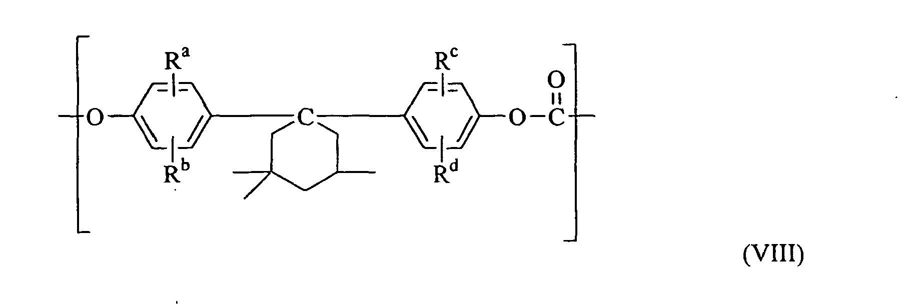 wherein R^{a}-R^{d} are as defined above. These isophorone bisphenol based polymers, including polycarbonate copolymers containing nonalkylcyclohexane bisphenols and blends of alkyl cyclohexyl bisphenol containing polycarbonates with nonalkyl-cyclohexyl bisphenol polycarbonates, are supplied by Bayer Co. under the APEC trade name. The preferred bisphenol compound is bisphenol A.

In one embodiment, the dihydroxy compound may be reacted with a hydroxyaryl-terminated poly(diorganosiloxane) to create a polycarbonate-polysiloxane copolymer. Preferably the polycarbonate-poly(diorganosiloxane) copolymers are made by introducing phosgene under interfacial reaction conditions into a mixture of a dihydroxy compound, such as BPA, and a hydroxyaryl-terminated poly(diorganosiloxane). The polymerization of the reactants can be facilitated by use of a tertiary amine catalyst or a phase transfer catalyst.

The hydroxyaryl-terminated poly(diorganosiloxane) can be made by effecting a platinum catalyzed addition between a siloxane hydride of the formula (IX), 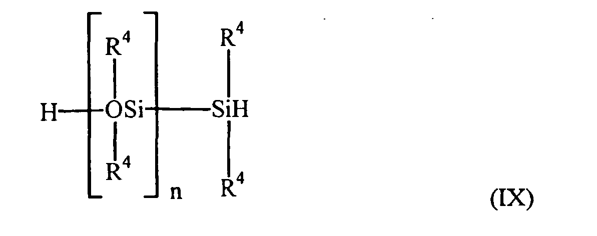 and an aliphatically unsaturated monohydric phenol wherein R⁴ is, for example, C₍₁₋₈₎ alkyl radicals, haloalkyl radicals such as trifluoropropyl and cyanoalkyl radicals; aryl radicals such as phenyl, chlorophenyl and tolyl. R⁴ is preferably methyl, or a mixture of methyl and trifluoropropyl, or a mixture of methyl and phenyl.

Some of the aliphatically unsaturated monohydric phenols, which can be used to make the hydroxyaryl-terminated poly(diorganosiloxane)s are, for example, eugenol, 2-alkylphenol, 4-allyl-2-methylphenol, 4-allyl-2-phenylphenol, 4-allyl-2-bromophenol, 4-allyl-2-t-butoxyphenol, 4-phenyl-2-phenylphenol, 2-methyl-4-propylphenol, 2-allyl-4,6-dimethylphenol, 2-allyl-4-bromo-6-methylphenol, 2-allyl-6-methoxy-4-methylphenol, 2-allyl-4,6-dimethylphenol, or the like, or a combination comprising at least one of the foregoing.

Typical carbonate precursors include the carbonyl halides, for example carbonyl chloride (phosgene), and carbonyl bromide; the bis-haloformates, for example the bis-haloformates of dihydroxy compounds such as bisphenol A, hydroquinone, or the like, and the bis-haloformates of glycols such as ethylene glycol and neopentyl glycol; and the diaryl carbonates, such as diphenyl carbonate, di(tolyl) carbonate, and di(naphthyl) carbonate. The preferred carbonate precursor for the interfacial reaction is carbonyl chloride.

It is also possible to employ polycarbonates resulting from the polymerization of two or more different dihydric phenols or a copolymer of a dihydric phenol with a glycol or with a hydroxy- or acid-terminated polyester or with a dibasic acid or with a hydroxy acid or with an aliphatic diacid in the event a carbonate copolymer rather than a homopolymer is desired for use. Generally, useful aliphatic diacids have about 2 to about 40 carbons. A preferred aliphatic diacid is dodecanedioic acid.

Branched polycarbonates, as well as blends of linear polycarbonate and a branched polycarbonate may also be used in the composition. The branched polycarbonates may be prepared by adding a branching agent during polymerization. These branching agents may comprise polyfunctional organic compounds containing at least three functional groups, which may be hydroxyl, carboxyl, carboxylic anhydride, haloformyl, and combinations comprising at least one of the foregoing branching agents. Specific examples include trimellitic acid, trimellitic anhydride, trimellitic trichloride, tris-p-hydroxy phenyl ethane, isatin-bis-phenol, tris-phenol TC (1,3,5-tris((p-hydroxyphenyl)isopropyl)benzene), tris-phenol PA (4(4(1,1-bis(p-hydroxyphenyl)-ethyl) α,α-dimethyl benzyl)phenol), 4-chloroformyl phthalic anhydride, trimesic acid, benzophenone tetracarboxylic acid, or the like, or combinations comprising at least one of the foregoing branching agents. The branching agents may be added at a level of about 0.05 to about 4.0 weight percent (wt%), based upon the total weight of the polycarbonate in a given layer.

In one embodiment, the polycarbonate may be produced by a melt polycondensation reaction between a dihydroxy compound and a carbonic acid diester. Examples of the carbonic acid diesters that may be utilized to produce the polycarbonates are diphenyl carbonate, bis(2,4-dichlorophenyl)carbonate, bis(2,4,6-trichlorophenyl) carbonate, bis(2-cyanophenyl) carbonate, bis(o-nitrophenyl) carbonate, ditolyl carbonate, m-cresyl carbonate, dinaphthyl carbonate, bis(diphenyl) carbonate, diethyl carbonate, dimethyl carbonate, dibutyl carbonate, dicyclohexyl carbonate, bis(o-methoxycarbonylphenyl)carbonate, bis(o-ethoxycarbonylphenyl)carbonate, bis(o-propoxycarbonylphenyl)carbonate, bis-ortho methoxy phenyl carbonate, bis(o-butoxycarbonylphenyl)carbonate, bis(isobutoxycarbonylphenyl)carbonate, o-methoxycarbonylphenyl-o-ethoxycarbonylphenylcarbonate, bis o-(tert-butoxycarbonylphenyl)carbonate, o-ethylphenyl-o-methoxycarbonylphenyl carbonate, p-(tertbutylphenyl)-o-(tert-butoxycarbonylphenyl)carbonate, bis-(ethyl salicyl) carbonate (this is bis(o-ethoxycarbonylphenyl)carbonate etc), bis(-propyl salicyl) carbonate, bis-butyl salicyl carbonate, bis- benzyl salicyl carbonate, bis-methyl 4-chlorosalicyl carbonate or the like, or combinations comprising at least one of the foregoing carbonic acid diesters. The preferred carbonic acid diester is diphenyl carbonate or bis(methyl salicyl) carbonate (BMSC).

Preferably, the weight average molecular weight of the polycarbonate is about 3,000 to about 1,000,000 grams/mole (g/mole). In one embodiment, the polycarbonate has a molecular weight of about 10,000 to about 100,000 g/mole. In another embodiment, the polycarbonate has a molecular weight of about 15,000 to about 50,000 g/mole. In yet another embodiment, the polycarbonate has a molecular weight of about 18,000 to about 40,000 g/mole.

The polyesters may be aliphatic polyesters, aromatic polyesters, aliphatic-aromatic polyesters, cycloaliphatic-aromatic polyesters, polyarylates or a combination of the foregoing. Cycloaliphatic polyesters suitable for use in the composition are those that are characterized by optical transparency, improved weatherability, chemical resistance, and low water absorption. It is also generally desirable that the cycloaliphatic polyesters have good melt compatibility with the thermoplastic polymers used in the composition. In an exemplary embodiment, it is preferred to use a cycloaliphatic polyester that displays good melt compatibility with the polycarbonate used in the composition. Cycloaliphatic polyesters are generally prepared by reaction of a cyclic diol with a diacid or derivative. The diacid may be aromatic or aliphatic. The diols useful in the preparation of the cycloaliphatic polyester polymers for use as the high quality optical sheets are straight chain, branched, or cycloaliphatic, preferably straight chain or branched alkane diols, and may contain from 2 to 12 carbon atoms.

Suitable examples of diols include ethylene glycol, propylene glycol such as 1,2- and 1,3-propylene glycol, and the like; butane diol such as 1,3- and 1,4-butane diol, and the like; diethylene glycol, 2,2-dimethyl-1,3-propane diol, 2-ethyl, 2-methyl, 1,3-propane diol, 1,3- and 1,5-pentane diol, dipropylene glycol, 2-methyl-1,5-pentane diol, 1,6-hexane diol, 1,4- cyclohexane dimethanol and particularly its cis- and trans-isomers, triethylene glycol, 1,10-decane diol, and combinations comprising at least one of the foregoing diols. Particularly preferred is dimethanol bicyclo octane, dimethanol decalin, a cycloaliphatic diol or chemical equivalents thereof, and particularly 1,4-cyclohexane dimethanol or its chemical equivalents. If 1,4-cyclohexane dimethanol is to be used as the diol component, it is generally preferred to use a mixture of cis- to trans-isomes in ratios of about 1:4 to about 4:1. Within this range, it is generally desired to use a ratio of cis- to trans- isomers of about 1:3.

The diacids useful in the preparation of the cycloaliphatic polyester polymers are aliphatic diacids that include carboxylic acids having two carboxyl groups each of which are attached to a saturated carbon in a saturated ring. Suitable examples of cycloaliphatic acids include decahydro naphthalene dicarboxylic acid, norbornene dicarboxylic acids, bicyclo octane dicarboxylic acids. Preferred cycloaliphatic diacids are 1,4-cyclohexanedicarboxylic acid and trans-1, 4-cyclohexanedicarboxylic acids. Linear aliphatic diacids are also useful provided the polyester has at least one monomer containing a cycloaliphatic ring. Illustrative examples of linear aliphatic diacids are succinic acid, adipic acid, dimethyl succinic acid, and azelaic acid. Mixtures of diacid and diols may also be used to make the cycloaliphatic polyesters.

Cyclohexanedicarboxylic acids and their chemical equivalents can be prepared, for example, by the hydrogenation of cycloaromatic diacids and corresponding derivatives such as isophthalic acid, terephthalic acid or naphthalenic acid in a suitable solvent (e.g., water or acetic acid) at room temperature and at atmospheric pressure using catalysts such as rhodium supported on a carrier comprising carbon and alumina. They may also be prepared by the use of an inert liquid medium wherein an acid is at least partially soluble under reaction conditions and a catalyst of palladium or ruthenium in carbon or silica is used.

Generally, during hydrogenation, two or more isomers are obtained in which the carboxylic acid groups are in cis- or trans-positions. The cis- and trans-isomers can be separated by crystallization with or without a solvent, for example, n-heptane, or by distillation. The cis-isomer tends to be more miscible, however, the trans-isomer has higher melting and crystallization temperatures and is especially preferred. Mixtures of the cis- and trans-isomers may also be used, and preferably when such a mixture is used, the trans-isomer will preferably comprise at least about 75 wt% and the cis-isomer will comprise the remainder based on the total weight of cis- and trans-isomers combined. When a mixture of isomers or more than one diacid is used, a copolyester or a mixture of two polyesters may be used as the cycloaliphatic polyester polymer.

Chemical equivalents of these diacids including esters may also be used in the preparation of the cycloaliphatic polyesters. Suitable examples of the chemical equivalents of the diacids are alkyl esters, e.g., dialkyl esters, diaryl esters, anhydrides, acid chlorides, acid bromides, and the like, as well as combinations comprising at least one of the foregoing chemical equivalents. The preferred chemical equivalents comprise the dialkyl esters of the cycloaliphatic diacids, and the most preferred chemical equivalent comprises the dimethyl ester of the acid, particularly dimethyl-trans-1,4-cyclohexanedicarboxylate.

Dimethyl-1,4-cyclohexanedicarboxylate can be obtained by ring hydrogenation of dimethylterephthalate, and two isomers having the carboxylic acid groups in the cis- and trans-positions are obtained. The isomers can be separated, the trans-isomer being especially preferred. Mixtures of the isomers may also be used as detailed above.

The polyester polymers are generally obtained through the condensation or ester interchange polymerization of the diol or diol chemical equivalent component with the diacid or diacid chemical equivalent component and having recurring units of the formula (X): 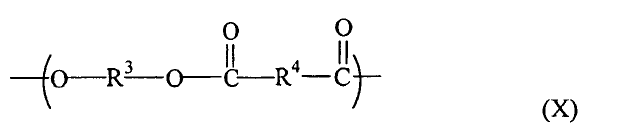 wherein R³ represents an alkyl or cycloalkyl radical containing 2 to 12 carbon atoms and which is the residue of a straight chain, branched, or cycloaliphatic alkane diol having 2 to 12 carbon atoms or chemical equivalents thereof; and R⁴ is an alkyl or a cycloaliphatic radical which is the decarboxylated residue derived from a diacid, with the proviso that at least one of R³ or R⁴ is a cycloalkyl group.

A preferred cycloaliphatic polyester is poly(1,4-cyclohexane-dimethanol-1,4-cyclohexanedicarboxylate) (PCCD) having recurring units of formula (XI) 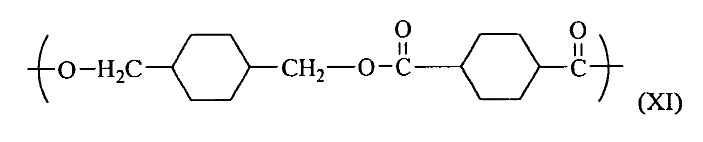 wherein in the formula (X) R³ is a dimethyl cyclohexane ring derived from cyclohexane dimethanol, and wherein R⁴ is a cyclohexane ring derived from cyclohexanedicarboxylate or a chemical equivalent thereof and is selected from the cis- or trans-isomer or a mixture of cis- and trans- isomers thereof. Cycloaliphatic polyester polymers can be generally made in the presence of a suitable catalyst such as a tetra(2-ethyl hexyl)titanate, in a suitable amount, generally about 50 to 400 ppm of titanium based upon the total weight of the final product.

PCCD is generally completely miscible with the polycarbonate. It is generally desirable for a polycarbonate- PCCD mixture to have a melt volume rate of greater than or equal to about 5 cubic centimeters/10 minutes (cc/10 min or ml/10 min)to less than or equal to about 150 cubic centimeters/10 minutes when measured at 265°C, at a load of 2.16 kilograms and a four minute dwell time. Within this range, it is generally desirable to have a melt volume rate of greater than or equal to about 7, preferably greater than or equal to about 9, and more preferably greater than or equal to about 10 cc/10 min when measured at 265°C, at a load of 2.16 kilograms and a four minute dwell time. Also desirable within this range, is a melt volume rate of less than or equal to about 125, preferably less than or equal to about 110, and more preferably less than or equal to about 100 cc/10 minutes.

Other preferred polyesters that may be mixed with the polycarbonate are polyethylene terephthalate (PET), polybutylene terephthalate (PBT), poly(trimethylene terephthalate) ( PTT), poly(cyclohexanedimethanol-co-ethylene terephthalate) ( PETG), poly(ethylene naphthalate) (PEN), and poly(butylene naphthalate) (PBN).

Another preferred polyester that may be mixed with other polymers are polyarylates. Polyarylates generally refers to polyesters of aromatic dicarboxylic acids and bisphenols. Polyarylate copolymers that include carbonate linkages in addition to the aryl ester linkages, are termed polyester-carbonates, and may also be advantageously utilized in the mixtures. The polyarylates can be prepared in solution or by the melt polymerization of aromatic dicarboxylic acids or their ester forming derivatives with bisphenols or their derivatives.

In general, it is preferred for the polyarylates to comprise at least one diphenol residue in combination with at least one aromatic dicarboxylic acid residue. The preferred diphenol residue, illustrated in formula (XII), is derived from a 1,3-dihydroxybenzene moiety, referred to throughout this specification as resorcinol or resorcinol moiety. Resorcinol or resorcinol moieties include both unsubstituted 1,3-dihydroxybenzene and substituted 1,3-dihydroxybenzenes.

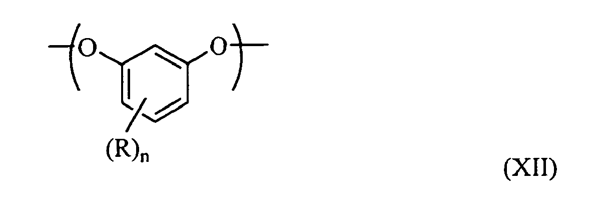

In formula (XII), (R)ₙ is C₁₋₁₂ alkyl or halogen, and n is 0 to 3. Suitable dicarboxylic acid residues include aromatic dicarboxylic acid residues derived from monocyclic moieties, preferably isophthalic acid, terephthalic acid, or mixtures of isophthalic and terephthalic acids, or from polycyclic moieties such as diphenyl dicarboxylic acid, diphenylether dicarboxylic acid, and naphthalene-2,6-dicarboxylic acid, and the like, as well as combinations comprising at least one of the foregoing polycyclic moieties. The preferred polycyclic moiety is naphthalene-2,6-dicarboxylic acid.

Preferably, the aromatic dicarboxylic acid residues are derived from mixtures of isophthalic and/or terephthalic acids as generally illustrated in formula (XIII).

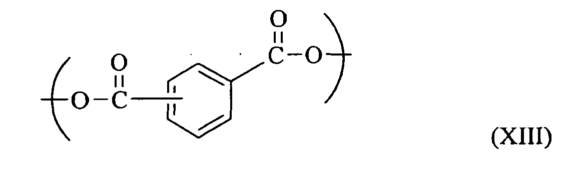

Therefore, in one embodiment the polyarylates comprise resorcinol arylate polyesters as illustrated in formula (XIV) wherein R and n are previously defined for formula (XII). 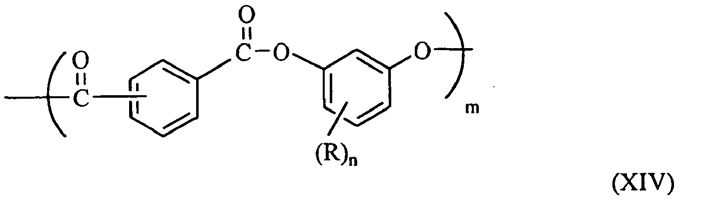 wherein (R)ₙ is C₁₋₁₂ alkyl or halogen, n is 0 to 3, and m is at least about 8. It is preferred for R to be hydrogen. Preferably, n is zero and m is about 10 and about 300. The molar ratio of isophthalate to terephthalate is about 0.25:1 to about 4.0:1.

In another embodiment, the polyarylate comprises thermally stable resorcinol arylate polyesters that have polycyclic aromatic radicals as shown in formula (XV) 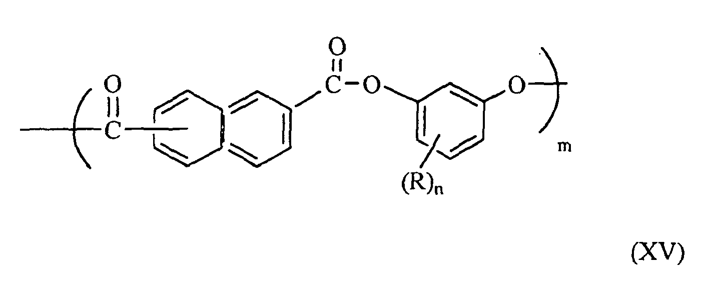 wherein (R)ₙ is at least one of C₁₋₁₂ alkyl or halogen, n is 0 to 3, and m is at least about 8.

In another embodiment, the polyarylates are copolymerized to form block copolyestercarbonates, which comprise carbonate and arylate blocks. They include polymers comprising structural units of the formula (XVI) 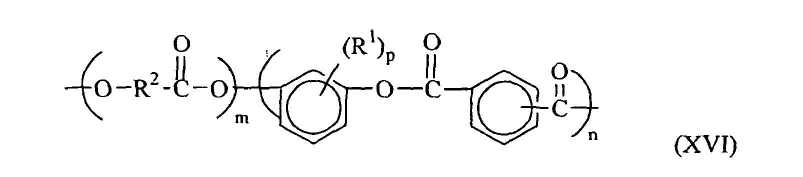 wherein each R¹ is independently halogen or C₁₋₁₂ alkyl, m is at least 1, p is an amount of up to 3, each R² is independently a divalent organic radical, and n is at least about 4. Preferably n is at least about 10, more preferably at least about 20 and most preferably about 30 to about 150. Preferably m is at least about 3, more preferably at least about 10 and most preferably about 20 to about 200. In an exemplary embodiment m is present in an amount of about 20 and 50.

It is generally desirable for the weight average molecular weight of the thermoplastic polymer to be about 500 to about 1,000,000 grams/mole (g/mole). In one embodiment, the thermoplastic polymer has a weight average molecular weight of about 10,000 to about 200,000 g/mole. In another embodiment, the thermoplastic polymer has a weight average molecular weight of about 30,000 to about 150,000 g/mole. In yet another embodiment, the thermoplastic polymer has a weight average molecular weight of about 50,000 to about 120,000 g/mole. An exemplary molecular weight for the thermoplastic polymer utilized in the composition is 15,000 and 120,000 g/mole.

The thermoplastic polymer and/or thermosetting polymer is generally used in amounts of about 70 to about 99.9 weight percent (wt%) based upon the weight of the composition. In one embodiment, the thermoplastic polymer and/or thermosetting polymer is present in an amount of about 75 to about 99.7 wt%, based on the total weight of the composition. In another embodiment, the thermoplastic polymer and/or thermosetting polymer is present in an amount of about 80 to about 99.5 wt%, based on the total weight of the composition. In yet another embodiment, the thermoplastic polymer and/or thermosetting polymer is present in an amount of about 85 to about 97 wt%, based on the total weight of the composition.

The inorganic IR absorbing additives are generally fine particles of a metal boride, particularly a boride such as lanthanum boride (LaB₆), praseodymium boride (PrB₆), neodymium boride (NdB₆), cerium boride (CeB₆), gadolinium boride (GdB₆), terbium boride (TbB₆), dysprosium boride (DyB₆), holmium boride (HoB₆), yttrium boride (YB₆), samarium boride (SmB₆), europium boride (EuB₆), erbium boride (ErB₆), thulium boride (TmB₆), ytterbium boride (YbB₆), lutetium boride (LuB₆), strontium boride (SrB₆), calcium boride (CaB₆), titanium boride (TiB₂), zirconium boride (ZrB₂), hafnium boride (HfB₂), vanadium boride (VB₂), tantalum boride (TaB₂), chromium borides (CrB and CrB₂), molybdenum borides (MoB₂, Mo₂B₅ and MoB), tungsten boride (W₂B₅), or combinations comprising at least one of the foregoing borides.

It is desirable for the inorganic IR absorbing additives to be in the form of nanosized particles prior to the dispersion into the thermoplastic and/or thermosetting polymer. There is no particular limitation to the shape of the particles, which may be for example, spherical, irregular, plate-like or whisker like. The nanosized particles may generally have average largest dimensions of less than or equal to about 200 nanometers (nm). In one embodiment, the particles may have average largest dimensions of less than or equal to about 150 nm. In another embodiment, the particles may have average largest dimensions of less than or equal to about 100 nm. In yet another embodiment, the particles may have average largest dimensions of less than or equal to about 75 nm. In yet another embodiment, the particles may have average largest dimensions of less than or equal to about 50 nm. As stated above, the nanosized particles may generally have average largest dimensions of less than or equal to about 200 nm. In one embodiment, more than 90% of the particles have average largest dimensions less than or equal to about 200 nm. In another embodiment, more than 95% of the particles have average largest dimensions less than or equal to about 200 nm. In yet another embodiment, more than 99% of the particles have average largest dimensions less than or equal to about 200 nm. Bimodal or higher particle size distributions may be used.

The inorganic IR absorbing additives are generally used in amounts of about 0.001 gram/square meter (g/m²) to about 2.0 g/m². In one embodiment, the inorganic IR absorbing additive may be used in amounts of about 0.03 to about 1.0 g/m². In another embodiment, the inorganic IR absorbing additive may be used in amounts of about 0.05 to about 0.75 g/m². In yet another embodiment, the inorganic IR absorbing additive may be used in amounts of about 0.09 to about 0.36 g/m².

The inorganic IR absorbing additives are generally used in amounts of about 0.02 ppm to about 3000 ppm based on the total weight of the composition. In one embodiment, the inorganic IR absorbing additive may be used in amounts of about 1 ppm to about 1500 ppm, based on the total weight of the composition. In another embodiment, the inorganic IR absorbing additive may be used in amounts of about 1.5 ppm to about 1250 ppm, based on the total weight of the composition. In yet another embodiment, the inorganic IR absorbing additive may be used in amounts of about 2.5 ppm to about 600 ppm, based on the total weight of the composition.

The composition comprises a suitable UV absorbing additive. The UV absorbing additive facilitates the preservation of the IR absorbing additive by increasing its hydrolytic stability. Suitable UV absorbing additives are benzophenones such as 2,4 dihydroxybenzophenone, 2-hydroxy-4-methoxybenzophenone, 2-hydroxy-4-n-octoxybenzophenone, 4-dodecyloxy-2 hydroxybenzophenone, 2-hydroxy-4-octadecyloxybenzophenone, 2,2' dihydroxy- 4 methoxybenzophenone, 2,2' dihydroxy-4,4'dimethoxybenzophenone, 2,2' dihydroxy-4 methoxybenzophenone, 2,2', 4,4' tetra hydroxybenzophenone, 2-hydroxy-4-methoxy-5 sulfobenzophenone, 2-hydroxy-4-methoxy-2'-carboxybenzophenone, 2,2'dihydroxy-4,4'dimethoxy-5 sulfobenzophenone, 2-hydroxy-4-(2-hydroxy-3-methylaryloxy) propoxybenzophenone, 2-hydroxy-4 chlorobenzopheone, or the like; benzotriazoles such as 2,2'-(hydroxy-5-methyl phenyl) benzotriazole, 2,2'-(hydroxy-3',5'-ditert-butyl phenyl) benzotriazole, and 2,2'-(hydroxy-X-tert, butyl-5'-methyl-phenyl) benzotriazole, or the like; salicylates such as phenyl salicylate, carboxyphenyl salicylate, p-octylphenyl salicylate, strontium salicylate, p-tert butylphenyl salicylate, methyl salicylate, dodecyl salicylate, or the like; and also other ultraviolet absorbents such as resorcinol monobenzoate, 2-ethylhexyl-2-cyano, 3-phenylcinnamate, 2-ethylhexyl-2-cyano-3,3-diphenyl acrylate, ethyl-2-cyano-3,3-diphenyl acrylate, 2-2'-thiobis(4-t-octylphenolate)-1-n-butylamine, or the like, or combinations comprising at least one of the foregoing UV absorbing additives. Preferred commercially available UV absorbers are TINUVIN 234, TINUVIN 329, TINUVIN 350 and TINUVIN 360, commercially available from Ciba Specialty Chemicals; UV-5411 (also known as Cyasorb UV5411) commercially available from Cyanamid; and UVINOL 3030 commercially available from BASF. For articles formed by extrusion, UVINOL 3030 is particularly preferred due to its low volatility.

The UV absorbers are generally used in amounts of about 0.05 wt% to about 5 wt%, based upon the weight of the composition. In one embodiment, the UV absorber may be used in an amount of 0.1 to about 0.5 wt%, based on the total weight of the composition. In yet another embodiment, the UV absorber may be used in an amount of 0.2 to about 0.4 wt%, based on the total weight of the composition.

In one embodiment, the composition may optionally contain thermal stabilizers to compensate for the increase in temperature brought on by the interaction of the IR light with the inorganic IR absorbing additives. Additionally the addition of thermal stabilizers protects the material during processing operations such as melt blending. In general, a layer of thermoplastic polymer containing the inorganic IR absorbing additives may experience an increase in temperature of up to about 20°C, upon exposure to light. The addition of thermal stabilizers to the composition improves the long term aging characteristics and increases the life cycle of the article.

In another embodiment thermal stabilizers may be optionally added to the composition to prevent degradation of the organic polymer during processing and to improve heat stability of the article. Suitable thermal stabilizers include phosphites, phosphonites, phosphines, hindered amines, hydroxyl amines, phenols, acryloyl modified phenols, hydroperoxide decomposers, benzofuranone derivatives, or the like, or combinations comprising at least one of the foregoing thermal stabilizers. Suitable thermal stabilizers that are commercially available are IRGAPHOS 168, DOVERPHOS S-9228, ULTRANOX 641, or the like. If desirable, an optional co-stabilizer such as a aliphatic epoxy or a hindered phenol anti-oxidant such as IRGANOX 1076, Irganox 1010, both from Ciba Specialty chemicals may also be added to improve thermal stability of the composition. The preferred thermal stabilizers are phosphites.

It is generally desirable to add the thermal stabilizer in an amount of about 0.001 to about 3 wt%, based on the total weight of the composition. In one embodiment, the thermal stabilizer may be added in amounts of about 0.002 to about 0.5 wt%, based on the total weight of the composition. In another embodiment, the thermal stabilizer may be added in amounts of about 0.005 to about 0.2 wt%, based on the total weight of the composition. In yet another embodiment, the thermal stabilizer may be added in amounts of about 0.01 to about 0.1 wt%, based on the total weight of the composition. If a co-stabilizer is added, it is generally desirable to add it in an amount of about 0.001 to about 2 wt%, based on the total weight of the composition.

In addition to the thermal stabilizers, other additives such as mold release agents, pigments, dyes, impact modifiers, lubricants, anti-oxidants, anti-microbials, flame retardants, visual effect additives, fibers such as carbon fibers, glass fibers, carbon nanotubes, or the like; antistatic agents, plasticizers, fillers such as fumed silica, aerogels, carbon black, or the like; can be added to the composition.

The composition may be processed into articles such as films, sheets, multiwall sheets, plaques, and the like. The composition is generally compounded and either melt or solution blended in devices that can impart shear to the composition to disperse the inorganic IR absorbing additive and the UV absorbing additive. It is desirable to melt blend the composition. Suitable examples of such blending devices are extruders (e.g., single and twin screw extruders), Buss kneaders, helicones, Waring blenders, Henschel mixers, Banbury mixers, a molding machine such as an injection molding machine, a blow molding machine, a vacuum forming machine, and the like. When the composition is melt blended in an extruder, Buss kneader, Banbury mixer, helicone, Waring Blender, Henschel mixers, or the like, it may be optionally desirable to further subject the melt blend to additional shearing in a roll mill. A preferred method of blending is in an injection molding machine.

In one embodiment, articles manufactured from the composition may comprise multilayered sheets. Such multilayered sheets may generally be produced by extrusion followed by laminating the sheets in a roll mill or a roll stack. The extrusion of the individual layers of the multilayered sheet may be performed in a single screw extruder or in a twin screw extruder. It is desirable to extrude the layers in a single screw extruder and to laminate the layers in a roll mill. It is more desirable to co-extrude the layers in a single screw extruder or twin screw extruder and to optionally laminate the layers in a roll mill. The roll mill may be either a two roll or three roll mill, as is desired. Co-extrusion of the layers by single screw extruders is generally desirable for the manufacturing of the multilayered sheet.

In one embodiment, in the extrusion of an article from the composition, the additives (e.g., inorganic IR absorbing additive and the UV absorbing additive) may be added to the extruder along with the thermoplastic and/or thermosetting polymer at the feed throat. In another embodiment, in the extrusion of the article, the additives may be added to the extruder in the form of a masterbatch. While the thermoplastic polymer is fed to the throat of the extruder, the masterbatch may be fed either at the throat of the extruder or downstream or the throat. In one exemplary embodiment, in the production of the article, the thermoplastic polymer is fed to the throat of a single screw extruder while the inorganic IR absorbing additive and the UV absorbing additive are added in masterbatch form downstream of the feed throat.

In a multiwall article, the respective sheets that constitute the multiwall may have similar or different compositions as desired. In one embodiment, related to the manufacturing of multiwall articles such as films or sheets, the desired compositions for the article may be separately precompounded prior to coextrusion. In this event, the precompounded composition(s) may be first melt blended in a twin screw extruder, single screw extruder, Buss kneader, roll mill, or the like, prior to being formed into a suitable shapes such as pellets, sheets, and the like, for further co-extrusion. The precompounded compositions may then be fed into the respective extruders for co-extrusion.

As stated above, it is desirable to co-extrude the layers of the multilayered articles. In one embodiment, in one manner of co-extruding of the multilayered sheet, the melt streams (extrudates) from the various extruders are fed into a feed block die where the various melt streams are combined before entering the die. In another embodiment, the melt streams from the various extruders are fed into a multi-manifold internal combining die. The different melt streams enter the die separately and join just inside the final die orifice. In yet another embodiment, the melt streams from the various extruders are fed into a multi-manifold external combining die. The external combining dies have completely separate manifolds for the different melt streams as well as distinct orifices through which the streams leave the die separately, joining just beyond the die exit. The layers are combined while still molten and just downstream of the die. An exemplary die used in the production of the multilayered sheet is a feed block die. In an exemplary embodiment, the extruders used for the co-extrusion of the respective layers of the multilayer sheet are single screw extruders respectively. The co-extruded sheet may optionally be calendared in a roll mill if desired. The multilayered sheet generally has a thickness of about 0.5 to about 35 millimeters.

In yet another embodiment, the composition may be subjected to molding either prior to or after extrusion to manufacture an IR absorbent article. The molding may be compression molding, thermoforming, injection molding, gas assisted injection molding, vacuum forming, blow molding, or the like.

Preferred forms of the articles obtained from the compositions are films and sheets. A film is one having a thickness of less than or equal to about 1000 micrometers, while in general a sheet or a plaque has a thickness of greater than 1000 micrometers.

It is desirable for an article manufactured from the composition to absorb an amount of greater than or equal to about 90% of all the IR radiation incident upon the surface of the article. In one embodiment, the article may absorb an amount of greater than or equal to about 60% of all the IR radiation incident upon the surface of the article. In another embodiment, the article may absorb an amount of greater than or equal to about 50% of all the IR radiation incident upon the surface of the article. In yet another embodiment, the article may absorb an amount of greater than or equal to about 40% of all the IR radiation incident upon the surface of the article. In yet another embodiment, the article may absorb an amount of greater than or equal to about 20% of all the IR radiation incident upon the surface of the article. In yet another embodiment, the multilayered article may absorb an amount of greater than or equal to about 5% of all the IR radiation incident upon the surface of the article.

While it is generally desirable for the article to absorb as much electromagnetic radiation as possible in the IR region of the electromagnetic spectrum, it is desirable for the article to be transparent to light in the visible region of the electromagnetic spectrum. The visible region of the electromagnetic spectrum generally has wavelengths of about 400 to about 700 nm. It is desirable for the article to have a transmissivity to light in the visible region of greater than or equal to about 20%. In one embodiment, it is desirable for the article to have a transmissivity to light in the visible region of greater than or equal to about 30%. In another embodiment, it is desirable for the article to have a transmissivity to light in the visible region of greater than or equal to about 40%. In yet another embodiment, it is desirable for the article for have a transmissivity of greater than or equal to about 50%.

It is also desirable for the article to have a haze of less than or equal to about 5%. In one embodiment, the haze may be less than or equal to about 2%. In another embodiment, the haze may be less than or equal to about 1.8%. In another embodiment, the haze may be less than or equal to about 1.6%.

It is generally desirable for the article obtained from the composition to have no loss in IR absorption capabilities over a period of greater than or equal to about 2 years. In one embodiment, the article can absorb IR radiation without any substantial decrease in IR absorption capabilities for a period of greater than or equal to about 2 years. In another embodiment, the article can absorb IR radiation without any substantial decrease in IR absorption capabilities for a period of greater than or equal to about 10 years. In one embodiment, a loss in IR absorption capabilities (measured as loss in effective IR absorber content) may be less than or equal to about 7% over a period of 2 years when exposed to ambient weather conditions. In another embodiment, the loss in IR absorption capabilities may be less than or equal to about 5% over a period of 2 years when exposed to ambient weather conditions. In yet another embodiment, the loss in IR absorption capabilities may be less than or equal to about 4% over a period of 2 years when exposed to ambient weather conditions. In yet another embodiment, the loss in IR absorption capabilities may be less than or equal to about 10% over a period of 10 years when exposed to ambient weather conditions. The loss in IR absorption is measured as the difference between the initial amount of active IR absorption additive and the final amount of active IR absorption additive divided by the initial amount of IR absorption additive after a desired time period has elapsed.

The articles thus produced may be advantageously used in automobiles, residential and office buildings or other areas where heat produced by exposure to IR radiation is undesirable. In one embodiment, the articles may be used as roofing or glazing materials, after being co-extruded as multiwall sheets with air channels in between the walls as shown in Figure 1 which is a schematic depiction of a multiwall sheet wherein the respective sheets are separated by brackets and having air pockets in between the brackets. The sheet thickness is also depicted in Figure 1 and encompasses the brackets as well as the individual multilayer sheets. The brackets may also be made of a thermoplastic polymer such as those described above. In one embodiment, the bracket may be manufactured from polycarbonate, polyester, or polyestercarbonate-polyester.

In one embodiment, the article may optionally be coated with a coating to enhance various surface properties. The coating may be applied to improve scratch resistance, fog resistance, or the like, to improve antistatic properties, to facilitate easy cleaning of the surface, to provide anti-reflection properties, and the like.

The following examples, which are meant to be exemplary, not limiting, illustrate compositions and methods of manufacturing some of the various embodiments of the multilayered sheets using various materials and apparatus.

### EXAMPLES

### Example 1

This example was undertaken to demonstrate the benefits of incorporating the inorganic IR absorbing additive and the UV absorbing additive into a layer comprising a thermoplastic polymer. The compositions comprise a polycarbonate polymer (PC105 available from GE Plastics), an inorganic IR absorbing additive (LaB₆ commercially available from Sumitomo Corp.), and various UV absorbing additives shown in Table 1 below. The inorganic IR absorbing additive was added in the form of a masterbatch to the extruder. The masterbatch contained 0.25 wt% of LaB₆ in polycarbonate polymer. The different compositions as shown in Table 1 (comparative examples) and Table 2 (working examples) were prepared by melt blending the respective compositions on a Werner & Pfleiderer 25 millimeter (mm) intermeshing twin screw extruder at 300 rpm with barrel temperatures of 40-200-250-270-300-300-300-300°C respectively. Following extrusion, 2.5 mm thick color plaques were molded on an Engel 75Ton injection molding machine having 4 temperature zones set at 280-290-300-295°C respectively. The mold temperature was set at 90°C.

The content of active LaB₆ within the 2.5 mm thick specimen before- and after the Weathering-or Heat Aging (HA) test was measured through Transmission Fourier Transform Near Infrared (FTNIR) Spectroscopy on an Antaris MDS NIR system commercially available from Thermo Nicolet. The equipment was calibrated by measuring the total light absorption between 1000 and 1400 nanometers (nm) at various concentrations of up to 0.0070% LaB₆ in polycarbonate polymer. The calibration model is based on Partial Least Squares (PLS) and is used in the measuring program of the FT-NIR. This program is used for measuring the spectra and for subsequent calculations. Furthermore during each measurement the program performs a spectral region check. When the spectrum deviates by an amount of greater than 5% from the spectra obtained during the calibration, the program issues a warning in order to prevent contributions of any artifact to the final active LaB₆ content. The spectra are processed by performing an Internal Reference Correction at 1669 nm (Ar-CH first overtone), which corrects for differences in path length caused by variations in sample thickness.

Xenon weathering was performed on the polycarbonate plaques according to the ISO standard 4892-2A in a Xenon 1200 LM cabinet. Conditions applied were as follows: UV radiation utilized was obtained from a Xenon Arc lamp source equipped with a Suprax type filter (between 300-400 nm: 60 W/m²). The irrigation cycle used was a demineralized water rinse during 18 minutes followed by a dry period of 102 minutes. The temperature set point was chosen as 65°C (± 3°C). Heat aging was performed by subjecting the plaques to a temperature of 120°C at dry conditions in a Hereaus heating oven. As noted above Table 1 shows the composition and results for the comparative samples, while Table 2 shows the composition and results for the working examples.

**Table 1**

| Ingredient | Sample 1 | Sample 2 | Sample 3 |
|---|---|---|---|
| PC105 | 97.66 | 97.61 | 97.61 |
| PC Master Batch (0.28wt% LaB₆) | 2.34 | 2.34 | 2.34 |
| Irgafos 168 | -- | 0.05 | 0.05 |
| Tinuvin 234 | -- | -- | -- |
| Cyasorb UV5411 | -- | -- | -- |
| Tinuvin 350 | -- | -- | -- |
| Tinuvin 360 | -- | -- | -- |
| Physical properties | | | |
| Initial LaB₆ wt% | 0.00631 | 0.00654 | 0.00651 |
| LaB₆ wt% after 1800 hrs Heat Aging 120°C | 0.00615 | 0.00632 | 0.00626 |
| LaB₆ wt% after 1000 hrs Xenon weathering | 0.00581 | 0.00610 | 0.00609 |
| Relative decrease in LaB₆ wt% upon heat aging | 2.5 | 3.4 | 3.8 |
| Relative decrease in LaB₆ wt% upon Xenon weathering | 7.9 | 6.7 | 6.5 |

Table 1 shows a typical loss of about 6 to about 7 wt% in active LaB₆ content after 1000 hours of Xenon weathering, when no UV absorbing additive was added to the polycarbonate mixture. The plaques upon visual examination show a slight decrease in the typical greenish color of the LaB₆, which is consistent with the disappearance of LaB₆ in humid conditions.

**Table 2**

| Ingredients | Sample 4 | Sample 5 | Sample 6 | Sample 7 | Sample 8 | Sample 9 | Sample 10 | Sample 11 | Sample 12 | Sample 13 | Sample 14 |
|---|---|---|---|---|---|---|---|---|---|---|---|
| PC105 | 97.51 | 97.31 | 97.51 | 97.31 | 97.51 | 97.31 | 97.51 | 97.31 | 97.31 | 97.31 | 97.31 |
| PC Master Batch (0.28% LaB6) | 2.34 | 2.34 | 2.34 | 2.34 | 2.34 | 2.34 | 2.34 | 2.34 | 2.34 | 2.34 | 2.34 |
| Irgafos 168 | 0.05 | 0.05 | 0.05 | 0.05 | 0.05 | 0.05 | 0.05 | 0.05 | 0.05 | 0.05 | 0.05 |
| Tinuvin 234 | 0.1 | 0.3 | -- | -- | -- | -- | -- | -- | 0.3 | -- | 0.3 |
| Tinuvin 5411 | -- | -- | 0.1 | 0.3 | -- | -- | -- | -- | -- | 0.3 | -- |
| Tinuvin 350 | -- | -- | -- | -- | 0.1 | 0.3 | -- | -- | -- | -- | -- |
| Tinuvin 360 | -- | -- | -- | -- | -- | -- | 0.1 | 0.3 | -- | -- | -- |
| Initial LaB₆ wt% | 0.00645 | 0.00686 | 0.00647 | 0.00658 | 0.00697 | 0.00688 | 0.00656 | 0.00667 | 0.00669 | 0.00667 | 0.00665 |
| LaB₆ wt% after 1800 hrs Heat Aging 120°C | 0.00626 | 0.00661 | 0.00629 | 0.00639 | 0.00672 | 0.00671 | 0.00635 | 0.00646 | 0.00648 | 0.00646 | 0.00643 |
| LaB₆ wt% after 1000 hrs Xenon weathering | 0.00619 | 0.00665 | 0.00622 | 0.00638 | 0.00674 | 0.00662 | 0.00635 | 0.00644 | 0.0065 | 0.00646 | 0.00645 |
| Relative decrease in LaB₆ wt% upon heat aging | 2.9 | 3.6 | 2.8 | 2.9 | 3.6 | 2.5 | 3.2 | 3.1 | 3.1 | 3.1 | 3.3 |
| Relative decrease in LaB₆ wt% upon Xenon weathering | 4.0 | 3.1 | 3.9 | 3.0 | 3.3 | 3.8 | 3.2 | 3.4 | 2.8 | 3.1 | 3.0 |

From Table 2 it may be seen that by adding the UV absorbing additive to the composition, the IR shielding retention is improved because of the preservation of the LaB₆. Without wishing to be bound by theory, it is speculated that there is an unexpected synergistic interaction between the UV absorbing additive and the inorganic IR absorbing additive, which improves the hydrolytic stability of the inorganic IR absorbing additive and thereby facilitates the preservation of the inorganic IR absorbing additive. This preservation of the inorganic IR absorbing additive facilitates the retention of the IR absorbing properties of the composition and the articles manufactured from the composition.

In one embodiment, the infrared absorption retention of the composition or an article manufactured from the composition is greater than or equal to about 96% after 1000 hours of exposure to Xenon weathering. In another embodiment, the infrared absorption retention of the composition or an article manufactured from the composition is greater than or equal to about 97% after 1000 hours of exposure to Xenon weathering. In yet another embodiment, the infrared absorption retention of the composition or an article manufactured from the composition is greater than or equal to about 98% after 1000 hours of exposure to a Xenon weathering.

## Claims

1. A composition comprising:
an organic polymer;
an inorganic infrared absorbing additive comprising lanthanum boride (LaB₆), praseodymium boride (PrB₆), neodymium boride (NdB₆), cerium boride (CeB₆), gadolinium boride (GdB₆), terbium boride (TbB₆), dysprosium boride (DyB₆), holmium boride (HoB₆), yttrium boride (YB₆), samarium boride (SmB₆), europium boride (EuB₆), erbium boride (ErB₆), thulium boride (TmB₆), ytterbium boride (YbB₆), lutetium boride (LuB₆), strontium boride (SrB₆), calcium boride (CaB₆), titanium boride (TiB₂), zirconium boride (ZrB₂), hafnium boride (HfB₂), vanadium boride (VB₂), tantalum boride (TaB₂), chromium borides (CrB and CrB₂), molybdenum borides (MoB₂, Mo₂B₅ and MoB), tungsten boride (W₂B₅), or a combination comprising at least one of the foregoing borides; and
a UV absorbing additive.

2. The composition of Claim 1, wherein the organic polymer is a thermoplastic polymer, a thermosetting polymer or a blend of a thermoplastic polymer with a thermosetting polymer.

3. The composition of Claim 2, wherein the thermoplastic polymer is a bisphenol A polycarbonate, a copolyestercarbonate, or a blend of polyester with polycarbonate.

4. The composition of Claim 3, wherein the polyester is a cycloaliphatic polyester, a polyarylate or a combination of a cycloaliphatic polyester with a polyarylate.

5. The composition of Claim 4, wherein the cycloaliphatic polyester has the structure (XI)

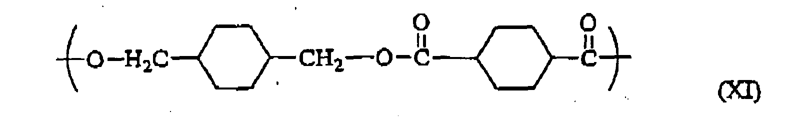

6. The composition of Claim 4, wherein the polyarylate is a resorcinol arylate polyester having the structure (XII) 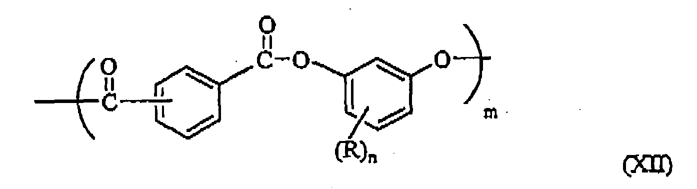 or the structure (XV) 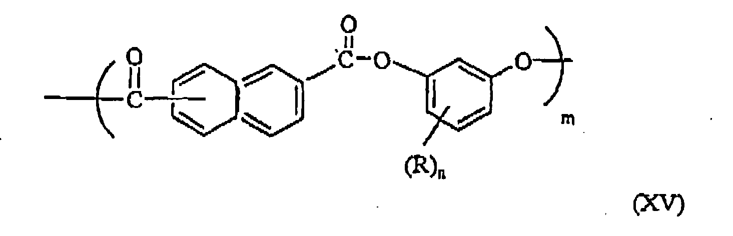 where R is a C₁₋₁₂ alkyl or halogen, n is 0 to 3, and m is at least about 8.

7. The composition of Claim 4, wherein the polyarylates are further copolymerized to form block copolyestercarbonates, comprising structural units of the formula (XVI) 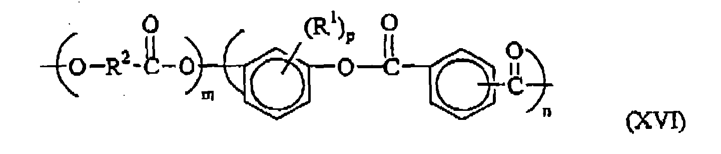 wherein each R¹ is independently halogen or C₁₋₁₂ alkyl, m is at least 1, p is about 0 to about 3, each R² is independently a divalent organic radical, and n is at least about 4.

8. The composition of any preceding Claim, wherein the inorganic infrared absorbing additive comprises nanosized particles having average particle dimensions of less than or equal to about 200 nanometers.

9. The composition of any preceding Claim, wherein the inorganic infrared absorbing additive is present in amounts of about 0.001 to about 2.0 gram/square meter, measured with respect to the surface area of an article manufactured from the composition.

10. The composition of any preceding Claim, wherein the inorganic infrared absorbing additive is present in amounts of about 0.02 parts per million to about 3000 parts per million based on the total weight of the composition.

11. The composition of any preceding Claim, wherein the ultraviolet absorbers are benzophenones, benzotriazoles, salicylates, resorcinol monobenzoate, 2-ethylhexyl-2-cyano, 3-phenylcinnamate, 2-ethyl-hexyl-2-cyano-3,3'-diphenyl acrylate, ethyl-2-cyano-3,3-diphenyl acrylate, 2,2'-thiobis(4-t-octylphenolate)-1-n-butylamine, or combinations comprising at least one of the foregoing UV absorbers and wherein the UV absorbers are present in an amount of 0.05 to about 5 wt%, based on the total weight of the composition.

12. The composition of Claim 1, having an infrared absorption of greater than or equal to about 20%.

13. The composition of Claim 1, having a transmissivity of greater than or equal to about 40% in the visible light region of an electromagnetic spectrum.

14. The composition of Claim 1, having an infrared absorption of greater than or equal to about 20%, an ultraviolet radiation absorption of greater than or equal to about 20%, and a transmissivity of greater than or equal to about 40% in the visible region of an electromagnetic spectrum.

15. The composition of any preceding Claim, further comprising thermal stabilizers, and further wherein the thermal stabilizers are phosphites, phosphonites, phosphines, hindered amines, hydroxyl amines, phenols, acryloyl modified phenols, hydroperoxide decomposers, benzofuranone derivatives, or a combination comprising at least one of the foregoing antioxidants and wherein thermal stabilizers are present in an amount of about 0.001 to about 3 wt%, based on the total weight of the composition.

16. The composition of Claim 1, wherein the infrared absorption retention of the composition is greater than or equal to about 96% after 1000 hours of exposure to a Xenon weathering source according to ISO 4892-2A conditions.

17. A method of manufacturing a composition comprising:
melt blending a composition comprising an organic polymer; an inorganic infrared absorbing additive comprising lanthanum boride (LaB₆), praseodymium boride (PrB₆), neodymium boride (NdB₆), cerium boride (CeB₆), gadolinium boride (GdB₆), terbium boride (TbB₆), dysprosium boride (DyB₆), holmium boride (HoB₆), yttrium boride (YB₆), samarium boride (SmB₆), europium boride (EuB₆), erbium boride (ErB₆), thulium boride (TmB₆), ytterbium boride (YbB₆), lutetium boride (LuB₆), strontium boride (SrB₆), calcium boride (CaB₆), titanium boride (TiB₂), zirconium boride (ZrB₂), hafnium boride (HfB₂), vanadium boride (VB₂), tantalum boride (TaB₂), chromium borides (CrB and CrB₂), molybdenum borides (MoB₂, Mo₂B₅ and MoB), tungsten boride (W₂B₅), or a combination comprising at least one of the foregoing borides; and a ultraviolet absorbing additive.

18. The method of Claim 17, wherein the melt blending is achieved through an application of shear and wherein the shear is applied in an extruder, a Buss kneader, a roll mill, a Henschel, a Waring blender, a helicone, a molding machine, or a combination comprising at least one of the foregoing methods of applying shear.

19. The method of Claim 17, wherein the melt blending is accomplished in a coextrusion process.

20. The method of Claim 17 further comprising molding the composition through compression molding, injection molding, blow molding, vacuum forming, thermoforming, gas assisted injection molding, or a combination comprising at least one of the foregoing methods of molding.

21. The method of Claim 20, further comprising coating the composition.

22. An article manufactured from the composition of any one of Claims 1 to 16 or manufactured by the method of any one of Claims 17 to 21.

## Patentansprüche

1. Eine Zusammensetzung die folgendes umfaßt:
ein organisches Polymer;
einen anorganischen Infrarot-absorbierenden Zusatzstoff, umfassend Lanthanborid (LaB₆), Praseodymborid (PrB₆), Neodymborid (NdB₆), Cerborid (CeB₆), Gadoliniumborid (GdB₆), Terbiumborid (TbB₆), Dysprosiumborid (DyB₆), Holmiumborid (HoB₆), Yttriumborid (YB₆), Samariumborid (SmB₆), Europiumborid (EuB₆), Erbiumborid (ErB₆), Thuliumborid (TmB₆), Ytterbiumborid (YbB₆), Lutetiumborid (LuB₆), Strontiumborid (SrB₆), Calciumborid (CaB₆), Titanborid (TiB₂), Zirconiumborid (Zr-B₂), Hafniumborid (HfB₂), Vanadiumborid (VB₂) , Tantalborid (TaB₂) , Chromboride (CrB und CrB₂), Molybdänboride (MoB₂, Mo₂B₅ und MoB), Wolframborid (W₂B₅) oder eine Kombination, die mindestens eines der obengenannten Boride umfasst; und
einen UV-absorbierenden Zusatzstoff.

2. Die Zusammensetzung gemäß Anspruch 1, worin das organische Polymer ein thermoplastisches Polymer, ein duroplastisches Polymer oder eine Mischung aus einem thermoplastischen Polymer und einem duroplastischen Polymer ist.

3. Die Zusammensetzung gemäß Anspruch 2, worin das thermoplastische Polymer ein Bisphenol A-Polycarbonat, ein Copolyestercarbonat oder eine Mischung aus Polyester und Polycarbonat ist.

4. Die Zusammensetzung gemäß Anspruch 3, worin der Polyester ein cycloaliphatischer Polyester, ein Polyarylat oder eine Kombination aus einem cycloaliphatischen Polyester und einem Polyarylat ist.

5. Die Zusammensetzung gemäß Anspruch 4, worin der cycloaliphatische Polyester die Struktur (XI) hat

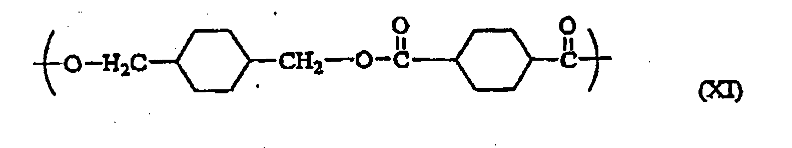

6. Die Zusammensetzung gemäß Anspruch 4, worin das Polyarylat ein Resorcinolarylatpolyester ist, mit der Struktur (XII) 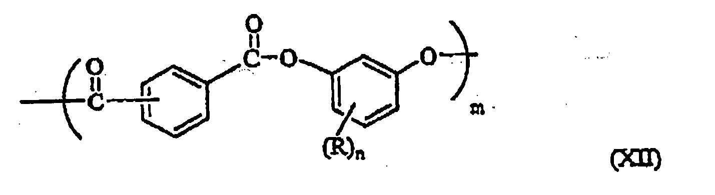 oder der Struktur (XV) 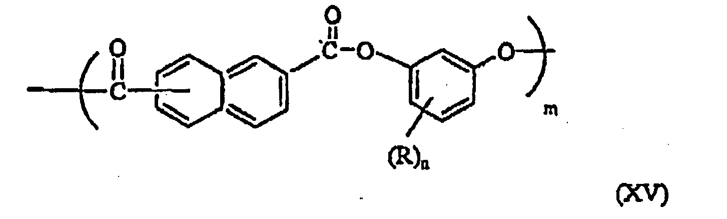 worin R ein C₁₋₁₂-Alkyl oder Halogen ist, n 0 bis 3 ist und m mindestens ungefähr 8 ist.

7. Die Zusammensetzung gemäß Anspruch 4, worin die Polyarylate weiter copolymerisiert sind, um Blockcopolyestercarbonate zu bilden, umfassend strukturelle Einheiten mit der Formel (XVI) 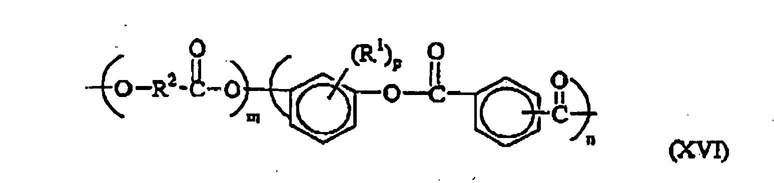 worin jedes R¹ unabhängig Halogen oder C₁₋₁₂-Alkyl ist, m mindestens 1 ist, p ungefähr 0 bis ungefähr 3 ist, jedes R² unabhängig ein zweiwertiges organisches Radikal ist und n mindestens ungefähr 4 ist.

8. Die Zusammensetzung gemäß einem beliebigen vorhergehenden Anspruch, worin der anorganische Infrarot-absorbierende Zusatzstoff Partikel in Nanogröße umfaßt, die durchschnittliche Partikelausmaße von weniger als oder gleich ungefähr 200 Nanometern haben.

9. Die Zusammensetzung gemäß einem beliebigen vorhergehenden Anspruch, worin der anorganische Infrarot-absorbierende Zusatzstoff in Mengen von ungefähr 0,001 bis ungefähr 2,0 Gramm/Quadratmeter vorhanden ist, gemessen hinsichtlich der Oberfläche eines Artikels, der aus der Zusammensetzung hergestellt wurde.

10. Die Zusammensetzung gemäß einem beliebigen vorhergehenden Anspruch, worin der anorganische Infrarot-absorbierende Zusatzstoff in Mengen von ungefähr 0,02 Teilen pro Million bis ungefähr 3000 Teilen pro Million, basierend auf dem Gesamtgewicht der Zusammensetzung, vorhanden ist.

11. Die Zusammensetzung gemäß einem beliebigen vorhergehenden Anspruch, worin die Ultraviolettabsorber Benzophenone, Benzotriazole, Salicylate, Resorcinolmonobenzoat, 2-Ethylhexyl-2-cyano, 3-Phenylcinnamat, 2-Ethyl-hexyl-2-cyano-3,3'-diphenylacrylat, Ethyl-2-cyano-3,3-diphenylacrylat, 2,2'-Thiobis(4-t-octylphenolat)-1-n-butylamin oder Kombinationen sind, die mindestens einen der zuvor genannten UV-Absorber umfassen, und worin die UV-Absorber in einer Menge von 0,05 bis ungefähr 5 Gewichtsprozent, basierend auf dem Gesamtgewicht der Zusammensetzung, vorhanden sind.

12. Die Zusammensetzung gemäß Anspruch 1, die eine Infrarotabsorption von größer als oder gleich ungefähr 20% hat.

13. Die Zusammensetzung gemäß Anspruch 1, die eine Transmission von größer als oder gleich ungefähr 40% im sichtbaren Lichtbereich eines elektromagnetischen Spektrums hat.

14. Die Zusammensetzung gemäß Anspruch 1, die eine Infrarotabsorption von größer als oder gleich ungefähr 20% hat, eine Ultraviolettstrahlungsabsorption von größer als oder gleich ungefähr 20% und eine Transmission von größer als oder gleich ungefähr 40% im sichtbaren Bereich eines elektromagnetischen Spektrums.

15. Die Zusammensetzung gemäß einem beliebigen vorhergehenden Anspruch, die weiter thermische Stabilisatoren umfaßt und worin weiter die thermischen Stabilisatoren folgende sind: Phosphite, Phosphonite, Phosphine, gehinderte Amine, Hydroxylamine, Phenole, Acryloyl-modifizierte Phenole, Hydroperoxidzersetzer, Benzofuranonderivate oder eine Kombination, die mindestens eines der vorhergehenden Antioxidantien umfaßt und worin thermische Stabilisatoren in einer Menge von ungefähr 0,001 bis ungefähr 3 Gewichtsprozent, basierend auf dem Gesamtgewicht der Zusammensetzung, vorhanden sind.

16. Die Zusammensetzung gemäß Anspruch 1, worin die Infrarotabsorptionsretention der Zusammensetzung nach 1000 Stunden Aussetzens gegenüber einer Xenonverwitterungsquelle gemäß ISO 4892-2A-Bedingungen größer als oder gleich ungefähr 96% ist.

17. Ein Verfahren zur Herstellung einer Zusammensetzung, das folgendes umfaßt:
Schmelzmischen einer Zusammensetzung, die folgendes umfaßt: ein organisches Polymer; einen anorganischen Infrarot-absorbierenden Zusatzstoff, umfassend Lanthanborid (LaB₆), Praseodymborid (PrB₆), Neodymborid (NdB₆) , Cerborid (CeB₆), Gadoliniumborid (GdB₆), Terbiumborid (TbB₆), Dysprosiumborid (DyB₆), Holmiumborid (HoB₆), Yttriumborid (YB₆), Samariumborid (SmB₆), Europiumborid (EuB₆) , Erbiumborid (ErB₆), Thuliumborid (TmB₆), Ytterbiumborid (YbB₆), Lutetiumborid (LuB₆), Strontiumborid (SrB₆), Calciumborid (CaB₆) , Titanborid (TiB₂) , Zirconiumborid (ZrB₂), Hafniumborid (HfB₂), Vanadiumborid (VB₂), Tantalborid (TaB₂), Chromboride (CrB und CrB₂), Molybdänboride (MoB₂, Mo₂B₅ und MoB), Wolframborid (W₂B₅), oder eine Kombination umfassend mindestens eines der obengenannten Boride; und einen Ultraviolett-absorbierenden Zusatzstoff.

18. Das Verfahren gemäß Anspruch 17, worin das Schmelzmischen erzielt wird durch eine Anwendung von Scherung und worin die Scherung in einem Extruder, einem Busskneter, einer Walzenmühle, einem Henschel, einem Waringmischer, einem Helikon, einer Formungsmaschine oder einer Kombination durchgeführt wird, die mindestens eines der zuvor genannten Verfahren zur Anwendung von Scherung umfaßt.

19. Das Verfahren gemäß Anspruch 17, worin das Schmelzmischen in einem Coextrusionsverfahren erreicht wird.

20. Das Verfahren gemäß Anspruch 17, das weiter das Formen der Zusammensetzung durch Formpressen, Spritzgießen, Blasformen, Vakuumformen, Thermoformen, Gas-unterstütztes Spritzgießen oder eine Kombination umfaßt, welche mindestens eines der zuvor genannten Verfahren von Formung umfaßt.

21. Das Verfahren gemäß Anspruch 20, das weiter das Beschichten der Zusammensetzung umfaßt.

22. Ein Artikel, hergestellt aus der Zusammensetzung gemäß einem beliebigen der Ansprüche 1 bis 16 oder hergestellt durch das Verfahren gemäß einem beliebigen der Ansprüche 17 bis 21.

## Revendications

1. Composition comprenant :
un polymère organique ;
un additif inorganique absorbant l'infrarouge, comprenant du borure de lanthane (LaB₆), du borure de praséodyme (PrB₆), du borure de néodyme (NdB₆), du borure de cérium (CeB₆), du borure de gadolinium (GdB₆) , du borure de terbium (TbB₆), du borure de dysprosium (DyB₆), du borure d'holmium (HoB₆), du borure d'yttrium (YB₆), du borure de samarium (SmB₆), du borure d'europium (EuB₆), du borure d'erbium (ErB₆), du borure de thulium (TmB₆), du borure d'ytterbium (YbB₆), du borure de lutétium (LuB₆), du borure de strontium (SrB₆), du borure de calcium (CaB₆), du borure de titane (TiB₂), du borure de zirconium (ZrB₂), du borure de hafnium (HfB₂), du borure de vanadium (VB₂), du borure de tantale (TaB₂), des borures de chrome (CrB et CrB₂), des borures de molybdène (MoB₂, Mo₂B₅ et MoB), du borure de tungstène (W₂B₅), ou une combinaison comprenant au moins l'un des borures précités ; et
un additif absorbant les UV.

2. Composition selon la revendication 1, dans laquelle le polymère organique est un polymère thermoplastique, un polymère thermodurcissable ou un mélange d'un polymère thermoplastique avec un polymère thermodurcissable.

3. Composition selon la revendication 2, dans laquelle le polymère thermoplastique est un polycarbonate de bisphénol A, un copolyestercarbonate, ou un mélange de polyester avec un polycarbonate.

4. Composition selon la revendication 3, dans laquelle le polyester est un polyester cycloaliphatique, un polyarylate ou une combinaison d'un polyester cycloaliphatique avec un polyarylate.

5. Composition selon la revendication 4, dans laquelle le polyester cycloaliphatique a la structure (XI)

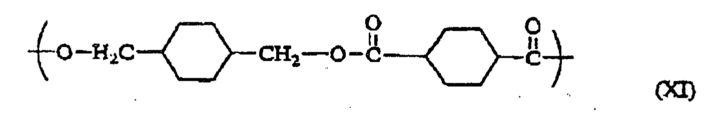

6. Composition selon la revendication 4, dans laquelle le polyarylate est un résorcinol arylate polyester ayant la structure (XII) 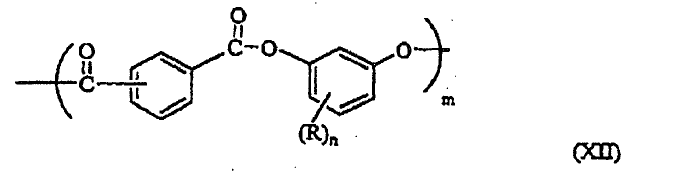 ou la structure (XV) 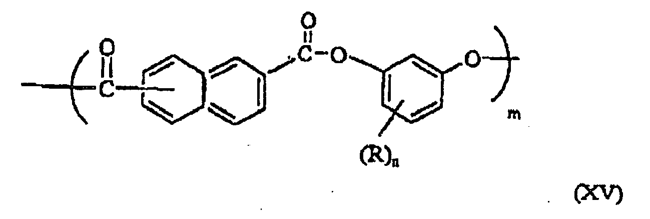 où R est un alkyle en C₁₋₁₂ ou un halogène, n est 0 à 3, et m est au moins environ 8.

7. Composition selon la revendication 4, dans laquelle les polyarylates sont ensuite copolymérisés pour former des copolyestercarbonates séquences, comprenant des motifs structuraux de formule (XVI) 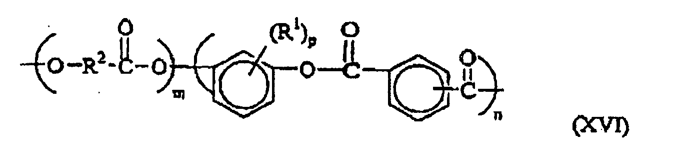 dans laquelle chaque R¹ est indépendamment un halogène ou un alkyle en C₁₋₁₂, m est au moins 1, p est environ 0 à environ 3, chaque R² est indépendamment un radical organique divalent, et n est au moins environ 4.

8. Composition selon l'une quelconque des revendications précédentes, dans laquelle l'additif inorganique absorbant l'infrarouge comprend des particules nanométriques ayant des dimensions moyennes de particules inférieures ou égales à environ 200 nanomètres.

9. Composition selon l'une quelconque des revendications précédentes, dans laquelle l'additif inorganique absorbant l'infrarouge est présent en des quantités d'environ 0,001 à environ 2,0 grammes/mètre carré, mesuré par rapport à la surface spécifique d'un article fabriqué à partir de la composition.

10. Composition selon l'une quelconque des revendications précédentes, dans laquelle l'additif inorganique absorbant l'infrarouge est présent en des quantités d'environ 0,02 partie par million à environ 3000 parties par million par rapport au poids total de la composition.

11. Composition selon l'une quelconque des revendications précédentes, dans laquelle les absorbeurs d'ultraviolet sont des benzophénones, des benzotriazoles, des salicylates, le monobenzoate de résorcinol, le 2-éthyl-hexyl-2-cyano, le cinnamate de 3-phényle, l'acrylate de 2-éthyl-hexyl-2-cyano-3,3'-diphényle, l'acrylate d'éthyl-2-cyano-3,3-diphényle, la 2,2'-thiobis(4-t-octylphénolate)-1-n-butylamine, ou des combinaisons comprenant au moins l'un des absorbeurs UV précités et dans laquelle les absorbeurs UV sont présents en une quantité de 0,05 à environ 5 % en poids, par rapport au poids total de la composition.

12. Composition selon la revendication 1, ayant une absorption d'infrarouge supérieure ou égale à environ 20 %.

13. Composition selon la revendication 1, ayant une transmissivité supérieure ou égale à environ 40 % dans la région de lumière visible d'un spectre électromagnétique.

14. Composition selon la revendication 1, ayant une absorption d'infrarouge supérieure ou égale à environ 20 %, une absorption de radiation ultraviolette supérieure ou égale à environ 20 % et une transmissivité supérieure ou égale à environ 40 % dans la région visible d'un spectre électromagnétique.

15. Composition selon l'une quelconque des revendications précédentes, comprenant en outre des stabilisants thermiques, et en outre dans laquelle les stabilisants thermiques sont des phosphites, des phosphonites, des phosphines, des amines empêchées, des hydroxyl amines, des phénols, des phénols modifiés par acryloyle, des décomposeurs d'hydroperoxydes, des dérivés de benzofuranone, ou une combinaison comprenant au moins l'un des antioxydants précités, et dans laquelle les stabilisants thermiques sont présents en une quantité d'environ 0,001 à environ 3 % en poids, par rapport au poids total de la composition.

16. Composition selon la revendication 1, dans laquelle la rétention d'absorption d'infrarouge de la composition est supérieure ou égale à environ 96 % après 1000 heures d'exposition à une source d'agents atmosphériques au xénon selon les conditions ISO 4892-2A.

17. Procédé de fabrication d'une composition, comprenant :
le mélange à l'état fondu d'une composition comprenant un polymère organique ; un additif inorganique absorbant l'infrarouge comprenant du borure de lanthane (LaB₆), du borure de praséodyme (PrB₆), du borure de néodyme (NdB₆), du borure de cérium (CeB₆), du borure de gadolinium (GdB₆), du borure de terbium (TbB₆) , du borure de dysprosium (DyB₆) , du borure d'holmium (HoB₆), du borure d'yttrium (YB₆), du borure de samarium (SmB₆), du borure d'europium (EuB₆), du borure d'erbium (ErB₆), du borure de thulium (TmB₆), du borure d'ytterbium (YbB₆), du borure de lutétium (LuB₆), du borure de strontium (SrB₆), du borure de calcium (CaB₆), du borure de titane (TiB₂), du borure de zirconium (ZrB₂) , du borure de hafnium (HfB₂), du borure de vanadium (VB₂), du borure de tantale (TaB₂), des borures de chrome (CrB et CrB₂), des borures de molybdène (MoB₂, MO₂B₅ et MoB), du borure de tungstène (W₂B₅), ou une combinaison comprenant au moins l'un des borures précités ; et un additif absorbant l'ultraviolet.

18. Procédé selon la revendication 17, dans lequel le mélange à l'état fondu est effectué par application d'un cisaillement et dans lequel le cisaillement est appliqué dans une extrudeuse, une malaxeuse Buss, un broyeur à rouleaux, un Henschel, un mélangeur Waring, un Helicone, une machine à mouler, ou une combinaison comprenant au moins l'un des procédés précités d'application de cisaillement.

19. Procédé selon la revendication 17, dans lequel le mélange à l'état fondu est accompli dans un procédé de coextrusion.

20. Procédé selon la revendication 17, comprenant en outre le moulage de la composition par moulage par compression, moulage par injection, moulage par soufflage, façonnage sous vide, thermoformage, moulage par injection assisté par un gaz, ou une combinaison comprenant au moins l'un des procédés de moulage précités.

21. Procédé selon la revendication 20, comprenant en outre l'application de la composition.

22. Article fabriqué à partir de la composition selon l'une quelconque des revendications 1 à 16 ou fabriqué par le procédé selon l'une quelconque des revendications 17 à 21.
